# EUROPEAN PATENT APPLICATION

(11) **EP 4 624 266 A1**
(43) Date of publication of application: **01.10.2025**
(21) Application number: 25157333.3
(22) Date of filing: 12.02.2025
(51) Int. Cl.: B60R 16/03, B60R 16/033, B60K 1/00, B60K 6/00, B60L 1/00, B60K 6/40, B60L 15/00

(54) **VEHICLE AND VEHICLE POWERTRAIN STRUCTURE**

(30) Priority: 28.03.2024 JP 2024054695
(71) Applicant: MAZDA MOTOR CORPORATION, Hiroshima 730-8670 (JP)
(72) Inventor: Shiba, Yoshihiro, Aki-gun, Hiroshima, 730-8670 (JP); Narukawa, Yuji, Aki-gun, Hiroshima, 730-8670 (JP); Nakatani, Yasushi, Aki-gun, Hiroshima, 730-8670 (JP); Okada, Masakazu, Aki-gun, Hiroshima, 730-8670 (JP); Yamasaki, Noriharu, Aki-gun, Hiroshima, 730-8670 (JP)
(74) Representative: Thoma, Michael

(57) **Abstract**

[Problem] To provide a vehicle powertrain structure capable of suppressing a height of a power converter to be low while suppressing an increase in an occupied area of the power converter.

[Solution] A vehicle V includes: a drive system having a motor M; an inverter 100 arranged in an upper portion of the drive system; and a DC bus bar LN2 connecting a circuit section of the inverter 100 and a DC connector CN1. An inverter housing 110 has: a housing main portion 111 extending in a front-rear direction along the drive system; and a downward protruding portion 121 protruding downward from a front end portion of the housing main portion 111. The circuit section includes: a main circuit component arranged other than a rear end area Ar1 overlapping the downward protruding portion 121 in a plan view; and a secondary circuit component arranged in the rear end area Ar1, and the DC bus bar LN2 is connected to the circuit section in the downward protruding portion 121.

## Description

### [Technical Field]

The present invention relates to a vehicle and a vehicle powertrain structure and, in particular, to a powertrain structure that includes a travel motor and a power converter.

### [Background Art]

In recent years, electric vehicles such as an electric automobile and a hybrid vehicle including a travel motor and a power converter have been well-known. The power converter is a device that converts electric power between a battery and the travel motor.

In order to reduce loss of supplied power to the travel motor, and from a perspective of space efficiency, the power converter is often arranged above the drive system including the travel motor. For example, a vehicle drive system is disclosed in Patent Literature 1 (another embodiment/FIG. 9). The vehicle drive system includes a travel motor, a transmission mechanism connected to the motor, and a drive system case for accommodating the motor and the transmission mechanism, and an inverter device (power converter) is arranged above the drive system case.

### [Citation List]

### [Patent Literature]

[Patent Literature 1] JP2014-113915A

### [Summary of Invention]

### [Technical Problem]

The drive system, above which the power converter is arranged, is likely to be enlarged in an up-down direction. For this reason, in order to accommodate the power converter in a limited space within a compartment while avoiding interference with the device arranged above, it is required that an upper surface height of the power converter is suppressed to be as low as possible. In this case, for example, it is considered to arrange components of the power converter as flat as possible, so as to make the entire device flat.

However, in this case, an occupied area of the entire device in a horizontal direction is increased, and the power converter is likely to interfere with peripheral devices during a vehicle collision. Accordingly, for a powertrain that includes the travel motor and the power converter, such a configuration is required that the upper surface height of the power converter can be suppressed to be low while an increase in the occupied area of the power converter in the horizontal direction is suppressed. However, such a devise is not described in Patent Literature 1.

The invention has been made in view of the above-described circumstance and therefore has a purpose of providing a vehicle and a vehicle powertrain structure capable of suppressing an upper surface height of a power converter to be low while suppressing an increase in an occupied area thereof.

### [Solution to Problem]

A vehicle powertrain structure according to the present invention includes: a drive system that is to be mounted on a vehicle and has a motor as a drive source for travel of the vehicle and a drive system housing at least accommodating the motor; a power converter that is arranged in an upper portion of the drive system and has a circuit section for power conversion between a battery and the motor and a converter housing accommodating the circuit section; a power supply connection portion that is arranged outside the converter housing and, to which a wire extending from the battery is connected; and a conductive member that connects the circuit section and the power supply connection portion. The converter housing has: a housing main portion that extends in a direction orthogonal to a rotation axis of the motor along the drive system; and a downward protruding portion that protrudes downward from an end portion of the housing main portion, the circuit section includes: a main circuit component that is a component having a power conversion function and is arranged in the housing main portion other than an overlapping area with the downward protruding portion in a plan view of the housing main portion; and a secondary circuit component that is another component and is arranged in said overlapping area, and the conductive member is connected to the circuit section in the downward protruding portion.

Here, "power conversion" means that at least one of a voltage, a current, a frequency, a phase, and the number of the phases as variables of electric power is converted into another form. For example, "power conversion" means conversion between DC power and AC power, conversion to increase/reduce the voltage, or the like.

According to the above powertrain structure, it is possible to suppress an upper surface height of the power converter to be low while suppressing an increase in an occupied area of the power converter. That is, when seen in an axial direction of a rotational shaft (that is, in a direction of a rotation axis), the motor has a circular stator and a rotor. Accordingly, an upper contour of the drive system housing often has an arc shape or a shape similar to the arc shape along a motor accommodation region in a side view. In the above powertrain structure, in view of the shape of the drive system housing, the converter housing has: the housing main portion that extends in the direction orthogonal to the rotation axis of the motor along the drive system; in other words the housing main portion may extend in the direction of the vehicle FR to the vehicle RR, and the downward protruding portion that protrudes downward from an end portion of the housing main portion. Then, the secondary circuit component is arranged in the area that overlaps the downward protruding portion in the plan view of the housing main portion, and the conductive member for connecting the circuit section and the power supply connection portion is connected to the downward protruding portion. Accordingly, it is possible to align the secondary circuit components downward from the housing main portion (in the downward protruding portion). As a result, is possible to suppress the upper surface height to be low while suppressing the increase in the occupied area of the power converter.

The vehicle powertrain structure may be configured that the circuit section includes a circuit wire that extends upward from a connection portion with the conductive member through inside of the downward protruding portion and that the secondary circuit component includes a noise filter component that is inserted in the circuit wire.

With this configuration, since the noise filter component is inserted in the circuit wire, it is possible to prevent noise generated in the power converter from being leaked to the wire on the power supply connection portion side from the portion of the circuit wire, in which the noise filter component is inserted, and on the battery side from the power supply connection portion (an electromagnetic interference (EMI) measure). In addition, also in the case where noise from another device is transmitted to the wire from the battery to the power supply connection portion, interference of the noise with driving of the power converter is prevented (an electromagnetic susceptibility (EMS) measure).

The above vehicle powertrain structure can be configured that the noise filter component at least includes a tubular ferrite core, that the ferrite core is arranged in the area in a state where a tube axis is along an up-down direction, and that the circuit wire is inserted through a tube of the ferrite core.

When a function as a noise filter is concerned, the ferrite core desirably has a shape that has a small inner diameter, is thick, and is long in a tube axis direction. In the above powertrain structure, it is possible to prevent the converter housing from being elongated in a horizontal direction (a vehicle front-rear direction and a vehicle width direction) while the function of the ferrite core as the noise filter as described above is concerned. That is, when the tube axis of the ferrite core is arranged in the up-down direction, it is possible to suppress the portion of the converter housing, in which the ferrite core is accommodated, from bulging in the horizontal direction (the vehicle front-rear direction and the vehicle width direction). In this way, in the plan view of the converter housing and the drive system housing, it is possible to prevent the converter housing from protruding from an outer shape line of the drive system housing. Thus, also during the vehicle collision, it is possible to suppress damage to the circuit wire inserted through the tube of the ferrite core, which is advantageous to ensure high safety.

In the above powertrain structure, the noise filter component may further include a Y capacitor, and the Y capacitor may be disposed at an overlapping position with the ferrite core in a plan view of the area, and may be connected to the circuit wire and the converter housing.

With this configuration, since, in addition to the ferrite core, the Y capacitor as the noise filter component is inserted in the circuit wire, it is possible to bypass the noise generated in the power converter and the noise from the outside to the ground, which establishes further advanced EMS/EMI measures.

In addition, since the Y capacitor is disposed at the overlapping position with the ferrite core in the plan view, it is possible to suppress the portion of the converter housing, in which the Y capacitor is accommodated, from bulging in the horizontal direction (the front-rear direction and the vehicle width direction).

The above powertrain structure further includes a terminal block that is arranged in the downward protruding portion and connects the circuit wire and the conductive member, and may be configured that the Y capacitor is arranged between the terminal block and a side wall portion of the downward protruding portion, and is connected to the circuit wire in the terminal block.

With this configuration, since the Y capacitor is arranged between the terminal block and the side wall portion of the downward protruding portion, it is possible to connect the Y capacitor to the circuit wire and the converter housing at a short distance. Moreover, since the Y capacitor is arranged compactly in the downward protruding portion together with the terminal block, it is possible to reduce a space of the area in the power converter, which is advantageous to suppress the increase in the occupied area of the power converter.

The above powertrain structure may be configured that the circuit wire includes: an inserted portion that is inserted through the tube of the ferrite core; and an extending portion, one end of which is connected to the inserted portion at a position above the ferrite core, and the other end of which is connected to the main circuit component.

In this configuration, a connection portion between the inserted portion and the extending portion in the circuit wire is arranged above the ferrite core. Accordingly, compared to a case where a connection portion between the inserted portion and the extending portion in the circuit wire is arranged at the position (outside) shifted from the position above the ferrite core, it is possible to suppress enlargement of the converter housing in the horizontal direction (the vehicle front-rear direction and the vehicle width direction). Thus, it is possible to suppress the portion of the converter housing, in which the ferrite core is accommodated, from bulging in the horizontal direction (the front-rear direction and the vehicle width direction), and it is thus possible to suppress the damage to the converter housing during the vehicle collision.

The above powertrain structure may be configured that the inserted portion and the extending portion are each formed of a bus bar, are fastened to each other, and are thereby connected to each other, and that the inserted portion is molded by an insulation resin together with a fastening member for fastening the inserted portion and the extending portion.

In this configuration, the inserted portion is molded by the insulation resin together with the fastening member for fastening the inserted portion and the extending portion. Accordingly, when the power converter is assembled, the inserted portion and the fastening member, which are molded in the tube of the ferrite core, are integrally inserted, and then the inserted portion and the extending portion can be fastened by using the fastening member at the position above the ferrite core. Thus, assemblability at the time of manufacturing the power converter is improved.

In the above configuration, since the inserted portion is molded, the busbars can be arranged as close to each other as possible. This is advantageous to reduce a diameter of the ferrite core and thus contributes to improvement in functionality of the ferrite core.

In addition, the above powertrain structure may be configured that the converter housing includes a refrigerant circulation path through which a refrigerant for cooling the circuit section circulates, and that the refrigerant circulation path is provided in the housing main portion other than the area described above.

In the case where the refrigerant circulation path is provided in the entire converter housing, it is necessary to provide the refrigerant circulation path three-dimensionally in the downward protruding portion, which complicates a cooling structure. However, in the above configuration, the secondary circuit component that is less likely to generate heat than the main circuit component is arranged in the area, and the refrigerant circulation path is provided other than the area of the housing main portion. Thus, it is possible to appropriately cool the main circuit component while avoiding complication of the cooling structure as described above.

In the above powertrain structure, the electrical connection portion may be disposed in a peripheral wall portion of the drive system housing, and the conductive member may be connected to the electrical connection portion through the inside of the conductor housing.

In this configuration, since the conductive member that connects the power supply connection portion and the circuit section is routed in the drive system housing, the conductive member is protected by the drive system housing during the vehicle collision. Thus, damage to the conductive wire is prevented even during the vehicle collision.

### [Advantageous Effects of Invention]

According to the invention that has been described so far, it is possible to provide the vehicle powertrain structure capable of suppressing the upper surface height to be low while suppressing the increase in the occupied area of the power converter.

### [Brief Description of Drawings]

[FIG. 1] FIG. 1 is a view illustrating a schematic configuration of a vehicle on which a powertrain according to an embodiment of the invention is mounted.
[FIG. 2] FIG. 2 is a view illustrating a power supply path between a battery and a motor.
[FIG. 3] FIG. 3 is a back view in which the powertrain is seen from behind.
[FIG. 4] FIG. 4 is a right view illustrating a part of a motor housing and an inverter.
[FIG. 5] FIG. 5 is a plan view in which the inverter is seen from above.
[FIG. 6] FIG. 6 is a perspective cross-sectional view illustrating a configuration of a DC input/output unit in the inverter.
[FIG. 7] FIG. 7 is a vertical cross-sectional view illustrating the configuration of the DC input/output unit in the inverter.
[FIG. 8] FIG. 8 is a plan view illustrating an overlapping area with a downward protruding terminal in an inverter housing (housing main portion).
[FIG. 9] FIG. 9 is a perspective view illustrating a configuration of a lower terminal block and an upper terminal block.
[FIG. 10] FIG. 10 is a perspective view illustrating a configuration of a lower terminal block and an upper terminal block (mainly, only a bus bar).
[FIG. 11] FIG. 11 is a plan view of a Y capacitor.

### [Description of Embodiments]

A detailed description will be made on an embodiment of the invention with reference to the drawings.

The invention will be exemplified in an embodiment described below.

### [Configuration of Vehicle V]

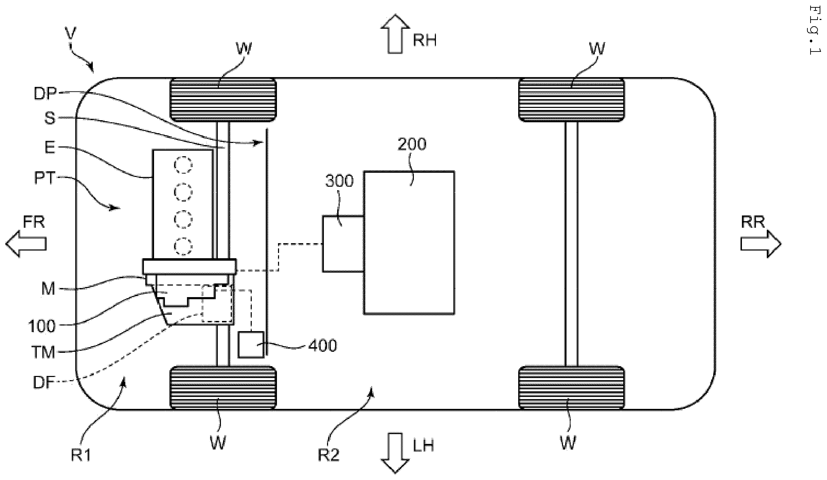

A description will be made on a configuration of a vehicle V according to an embodiment of the invention with reference to FIG. 1. In the drawings used in the following description, "FR" indicates a vehicle front direction, "RR" indicates a vehicle rear direction, "LH" indicates a vehicle left direction, "RH" indicates a vehicle right direction, "UP" indicates a vehicle up direction, and "LO" indicates a vehicle down direction. In addition, unless otherwise specifically described, a "front-rear direction" refers to a front-rear direction of the vehicle V.

As illustrated in FIG. 1, in the vehicle V, a powertrain PT that includes an inverter (power converter) 100 is mounted in a front powertrain room R1.

The vehicle V is a so-called hybrid electric vehicle (HEV). An engine E and a motor M as drive sources for travel (that is, drive sources for wheels W) are mounted on the vehicle V. That is, in the vehicle V, the engine E and the motor M constitute a drive system. The powertrain PT includes a transmission TM in addition to the engine E and the motor M.

The motor M that constitutes the drive system is a three-phase three-wire AC motor that is rotated when being supplied with three-phase AC power, and includes: a rotational shaft; a rotor that has a permanent magnet disposed around the rotational shaft; and a stator that is disposed on an outer periphery of the rotor and in which a coil is wound around each of plural teeth. The plural coils include a U-phase coil, a V-phase coil, and a W-phase coil, and currents in mutually different phases are supplied to the coils of the respective phases.

The transmission TM is connected to the motor M and decelerates the rotation that is input from the motor M. The transmission TM is integrated with a differential gear DF. Thus, the rotation that is input to the transmission TM is output to a driveshaft S via the differential gear DF and is transmitted to the wheels W.

The vehicle V according to an embodiment is a parallel hybrid electric vehicle as an example, and can travel by using only a driving force of the motor M, can travel by using the driving forces of both of the motor M and the engine E, and can travel by using only the driving force of the engine E. The vehicle V can perform deceleration regeneration, and the motor M generates the electric power by using a transmission force from the wheels W during deceleration of the vehicle V.

A battery 200 is mounted behind the powertrain PT, more specifically, under a floor of a cabin R2. The battery 200 exchanges the electric power with the motor M. When the motor M is driven as the drive source for travel, the battery 200 supplies the electric power to the motor M. In this case, DC power is supplied to the motor M via a DC/DC converter 300 that is provided in a power supply path between the battery 200 and the motor M.

Meanwhile, when the motor M is driven as a generator during the deceleration of the vehicle V, the battery 200 stores the electric power that is generated by the motor M.

The inverter 100 is connected to the three-phase three-wire motor M. The inverter 100 is a power converter that converts the DC power from the battery 200 into AC power and supplies the AC power to the motor M. More specifically, the inverter 100 converts the DC power, which is supplied from the battery 200 via a DC circuit including the DC/DC converter 300, into three-phase AC power, and supplies the three-phase AC power to the motor M.

In the case where the motor M is driven as the generator during the deceleration of the vehicle V, the inverter 100 converts the AC power, which is generated by the motor M, into the DC power and supplies the DC power to the battery 200 via the DC circuit including the DC/DC converter 300.

Although not illustrated in FIG. 1, the vehicle V also includes a low-voltage battery for supplying the electric power to an electrical component provided in each portion of the vehicle V. The low-voltage battery is a battery, a nominal voltage of which is lower than that of the battery 200.

Here, the battery 200 is a lithium-ion battery or a nickel-metal hydride battery, a nominal voltage of which is 24 V or higher, for example. The low-voltage battery is a lead battery or a lithium-ion battery, a nominal voltage of which is 12 V, for example.

A powertrain control module (PCM) 400 is also mounted on the vehicle V, and the PCM 400 is a controller that comprehensively controls the powertrain PT including the motor M and the engine E.

### [Electrical Connection Between Battery 200 and Powertrain PT]

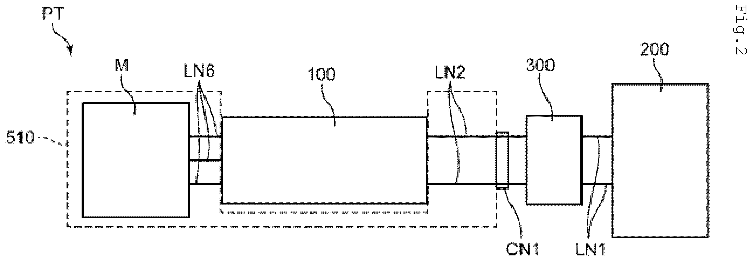

A description will be made on electrical connection between the battery 200 and the powertrain PT with reference to FIG. 2.

As illustrated in FIG. 2, the battery 200 is connected to the powertrain PT via the DC/DC converter 300. The powertrain PT has the motor M. The motor M is connected to the inverter 100 by an AC bus bar LN6. The inverter 100 is connected to the battery 200 via the DC/DC converter 300 by a power line harness LN1.

A DC connector (power supply connection portion) CN1 is disposed in a peripheral wall portion of a motor housing (drive system housing) 510 that accommodates the motor M. The power line harness LN1 is connected to the DC connector CN1. A DC bus bar (conductive member) LN2 that is connected to the DC connector CN1 is routed in the motor housing 510. The DC bus bar LN2 connects the DC connector CN1 and the inverter 100.

The DC power from the battery 200 is supplied to the inverter 100 via the DC/DC converter 300, is then converted into the AC power, and is supplied to the motor M. During deceleration of the vehicle V, the AC power, which is generated by the motor M, is converted into the DC power by the inverter 100 and supplied to the battery 200 via the DC/DC converter 300.

### [Arrangement of Each Portion in Powertrain PT]

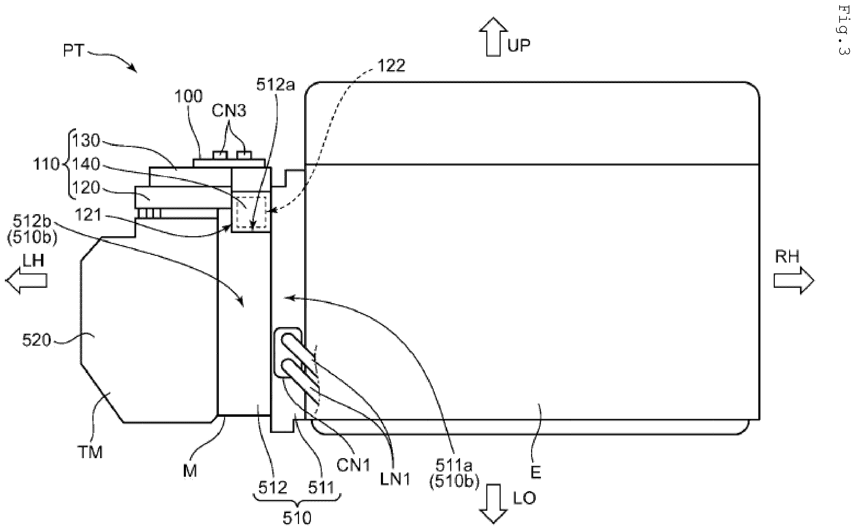

A description will be made on arrangement of each portion in the powertrain PT with reference to FIG. 3. FIG. 3 is a back view in which the powertrain PT is seen from the rear side of the vehicle V.

As illustrated in FIG. 3, the engine E, the motor M, and the transmission TM are sequentially arranged from right to left in the powertrain room R1. The engine E is, for example, a multi-cylinder reciprocating engine.

The motor M is disposed on a left side adjacent to a lower portion (cylinder block) of the engine E, and is accommodated in a motor housing 510 that includes a first motor housing 511 and a second motor housing 512. The first motor housing 511 and the second motor housing 512 each have a dish shape (a shallow dish shape or a deep dish shape), and are joined to each other in a state where opening edges thereof abut each other.

Here, although the motor M that is accommodated in the motor housing 510 is not illustrated in FIG. 3, the rotational shaft of the motor M is arranged to extend along a vehicle width direction.

Each of the first motor housing 511 and the second motor housing 512 is formed by using a conductive material (for example, a metallic material or a carbon fiber reinforced resin).

A DC connector CN1, to which the power line harness LN1 is connected, is disposed in a rear wall portion 511a of the first motor housing 511. The DC connector CN1 may be disposed in a rear wall portion 512b of the second motor housing 512. That is, the DC connector CN1 is disposed in a rear wall portion 510b as a part of a peripheral wall portion of the motor housing 510.

A recessed portion 512a that is recessed downward is provided in an upper rear portion of the second motor housing 512 in the motor housing 510. The recessed portion 512a is formed in a shape and a size that do not interfere with the motor M accommodated therein. When such the recessed portion 512a is provided, in a side view, a contour of the upper rear portion of the second motor housing 512 schematically has an arc shape or a similar shape thereto.

The transmission TM has an axle housing 520 as an outer shell. The axle housing 520 is joined (fastened) to a left portion of the second motor housing 512 in the motor housing 510 without a clearance therebetween. A transmission mechanism that constitutes the transmission TM and a gear mechanism that constitutes the differential gear DF are accommodated in the axle housing 520. The axle housing 520 is formed by using the conductive material (for example, the metallic material or the carbon fiber reinforced resin).

In the vehicle width direction of the vehicle V, the inverter 100 is arranged in a portion extending from an upper portion of the second motor housing 512 to an upper portion of the axle housing 520.

The inverter 100 includes an inverter housing (converter housing) 110 that constitutes an outer shell. The inverter housing 110 is configured by combining a housing body portion 120, a lid 130, and a cover 140. The housing body portion 120 has an opening in an upper portion thereof, and has a downward protruding portion 121 that enters the recessed portion 512a of the second motor housing 512.

The downward protruding portion 121 of the housing body portion 120 is provided with an opening 122 that is opened rearward (a front side of the sheet of FIG. 3). The opening 122 is a so-called service hole, and is a portion, from which a tool is inserted when work such as electrical connection is performed. The opening 122 is closed by the cover 140.

The lid 130 closes the opening of the housing body portion 120. The lid 130 is provided with plural (two as an example in an embodiment) PCM connectors CN3 in a manner to protrude upward. The PCM connectors CN3 are connectors for connecting the PCM 400 to the inverter 100.

Each of the housing body portion 120, the lid 130, and the cover 140 is formed by using the conductive material (for example, the metallic material or the carbon fiber reinforced resin).

### 4. Structure and Arrangement of Inverter 100

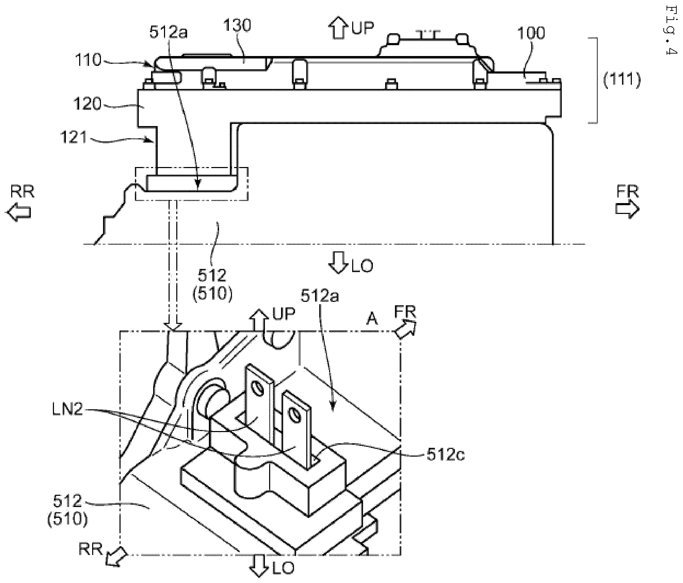

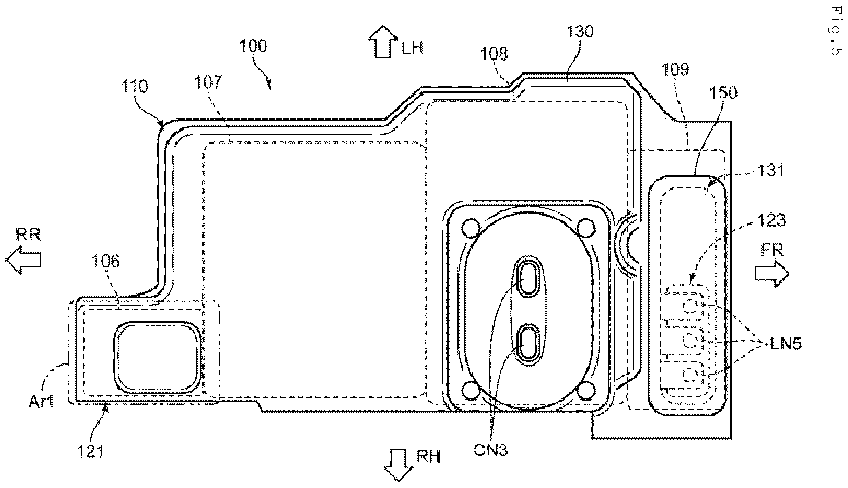

A description will be made on a structure and arrangement of the inverter 100 with reference to FIG. 4 and FIG. 5.

As illustrated in FIG. 4, in the front-rear direction of the vehicle V, the inverter housing 110 of the inverter 100 is arranged such that a rear end thereof is located in front of a rear end of the motor housing 510. Although the first motor housing 511 is not illustrated in FIG. 4, the rear end of the inverter housing 110 is arranged in front of a rear end of the first motor housing 511. A front end of the inverter housing 110 is flush with a front end of the first motor housing 511 or is arranged behind a front end of the first motor housing 511.

As described above, the housing body portion 120 of the inverter housing 110 has, in a rear end portion, the downward protruding portion 121 that protrudes downward. The other portions of the inverter housing 110 except for the downward protruding portion 121 is configured that a thickness in the up-down direction is substantially equal. Accordingly, it can be said that the downward protruding portion 121 is a portion that protrudes downward from the portion having the same thickness in the up-down direction (may also be referred to as a "housing main portion 111") of the inverter housing 110.

The downward protruding portion 121 enters the recessed portion 512a of the second motor housing 512, and a lower surface of the downward protruding portion 121 is joined to an upper surface of the recessed portion 512a. As illustrated in section A of FIG. 4, the DC bus bar LN2 protrudes upward from an opening 512c that is provided in the recessed portion 512a of the second motor housing 512, and enters the downward protruding portion 121. The DC bus bar LN2 is connected (joined) to a lower terminal block 640 (DC bus bar LN4) in the inverter 100. The opening 122 is used in the connection.

As illustrated in FIG. 5, the inverter 100 includes, in the inverter housing 110, a DC input/output unit 106, a smoothing unit 107, a power module unit 108, and an AC input/output unit 109 that are sequentially arranged in a direction from the rear end side toward the front end side. The DC input/output unit 106, the smoothing unit 107, the power module unit 108, and the AC input/output unit 109 each correspond to the "circuit section" in the invention. The power module unit 108 and the smoothing unit 107 each correspond to the "main circuit component" in the invention, and the DC input/output unit 106 corresponds to the "secondary circuit component" in the invention.

In a plan view of the inverter housing 110, an area Ar1 (hereinafter, referred to as the rear end area Ar1) in the rear end portion, in which the DC input/output unit 106 is accommodated, overlaps the downward protruding portion 121. In other words, in the inverter housing 110 (housing body portion 120), the downward protruding portion 121 is provided in the rear end area Ar1, and the DC input/output unit 106 is accommodated in this downward protruding portion 121. The rear end area Ar1 is generally formed to have a narrower width in the vehicle width direction than the other portion of the inverter housing 110, and is arranged at a position shifted to the right side. That is, in the rear end portion of the inverter housing 110, the downward protruding portion 121, in which the DC input/output unit 106 is accommodated, is arranged at the position shifted to the inner side in the vehicle width direction.

The smoothing unit 107 is configured to include a smoothing capacitor such as an electrolytic capacitor. An X capacitor may be disposed in the smoothing unit 107.

The power module unit 108 is configured by an insulated gate bipolar transistor (IGBT). However, the power module unit 108 does not always have to be configured by the IGBT, and may be configured by a known power module such as a metal oxide semiconductor field effect transistor (MOSFET) .

The AC input/output unit 109 includes an AC bus bar LN5 for connection with the motor M. The AC bus bar LN5 is connected to the AC bus bar LN6 (see FIG. 2) that extends from the motor M through an opening 123 provided to a bottom wall of the housing body portion 120 in the inverter housing 110.

An opening 131 is provided in an upper portion of the AC input/output unit 109 of the lid 130. The opening 131 is a so-called service hole, and is a portion, from which the tool is inserted when connection work between the AC bus bar LN5 and the AC bus bar LN6 is performed. The opening 131 is closed by a cover 150 that is formed of the conductive material (for example, the metallic material or the carbon fiber reinforced resin).

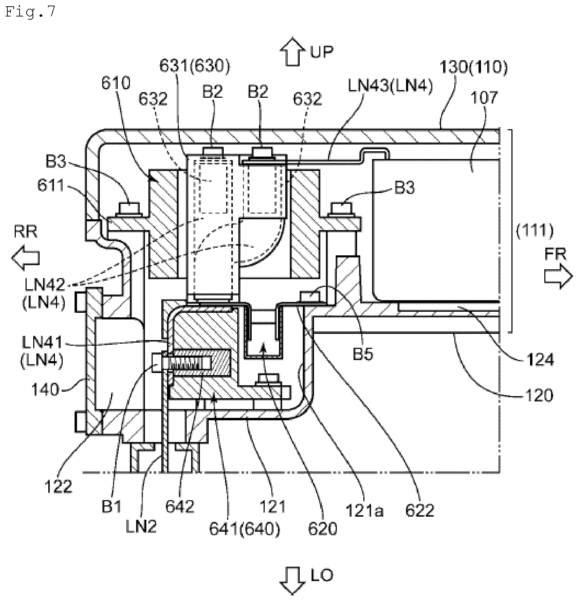

The housing body portion 120 of the inverter housing 110 is also provided with a refrigerant circulation path 124 (see FIG. 7) for cooling the smoothing unit 107 and the power module unit 108. The refrigerant circulation path 124 is a portion of the housing main portion 111 other than the rear end area Ar1, and is provided to meander along an inner bottom surface of the housing body portion 120. More specifically, the refrigerant circulation path 124 is provided to circulate through a region where the power module unit 108 and the smoothing unit 107 are arranged.

### [Configuration of DC Input/Output Unit 106 in Inverter 100]

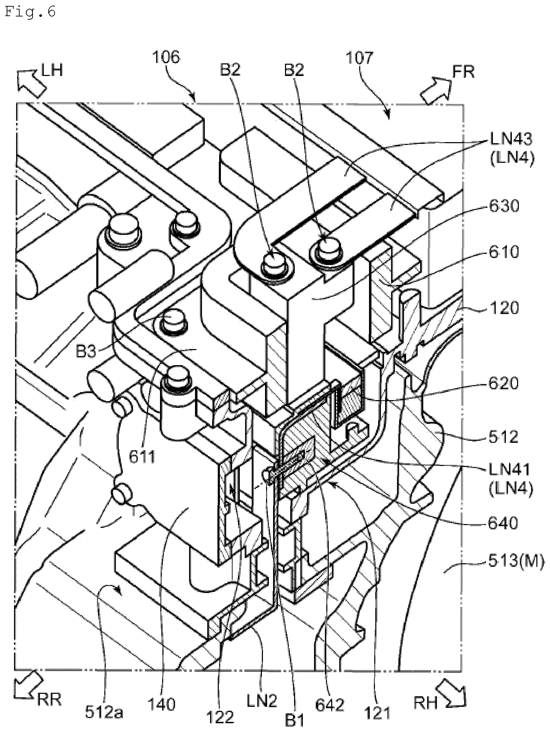

A description will be made on a configuration of the DC input/output unit 106 in the inverter 100 with reference to FIG. 6 to FIG. 11.

As illustrated in FIG. 6 and FIG. 7, the DC input/output unit 106 includes a ferrite core 610 and a Y capacitor 620 as noise filter components, an upper terminal block 630, and a terminal block 640, and is accommodated in the rear end area Ar1 of the inverter housing 110. In detail, the ferrite core 610 and the upper terminal block 630 are accommodated in the housing main portion 111 of the inverter housing 110, and the Y capacitor 620 and the terminal block 640 are accommodated in the downward protruding portion 121. That is, in the rear end area Ar1, the ferrite core 610 and the upper terminal block 630 are arranged above the Y capacitor 620 and the terminal block 640.

The ferrite core 610 is a member having a square tube shape, is arranged in a state where a tube axis is along the up-down direction, and is fixed to the housing body portion 120 by a bolt B3 via a surrounding flange portion 611. A lower end of the ferrite core 610 is located at the same position as or higher than an upper edge of the opening 122 that is provided in a rear portion of the downward protruding portion 121.

The upper terminal block 630 is arranged in the tube of the ferrite core 610, and the lower terminal block 640 is arranged below the upper terminal block 630.

The lower terminal block 640 is a connection portion that connects between the DC bus bar LN2 (see FIG. 4) protruding the downward protruding portion 121 from the second motor housing 512 and the DC bus bar LN4 as a circuit wire of the DC input/output unit 106.

As illustrated in FIG. 7, the DC bus bar LN4 is configured by a lower bus bar LN41, a middle bus bar LN42, and an upper bus bar LN43. The lower bus bar LN41 is provided in the terminal block 640, and the middle bus bar LN42 is provided in the upper terminal block 630.

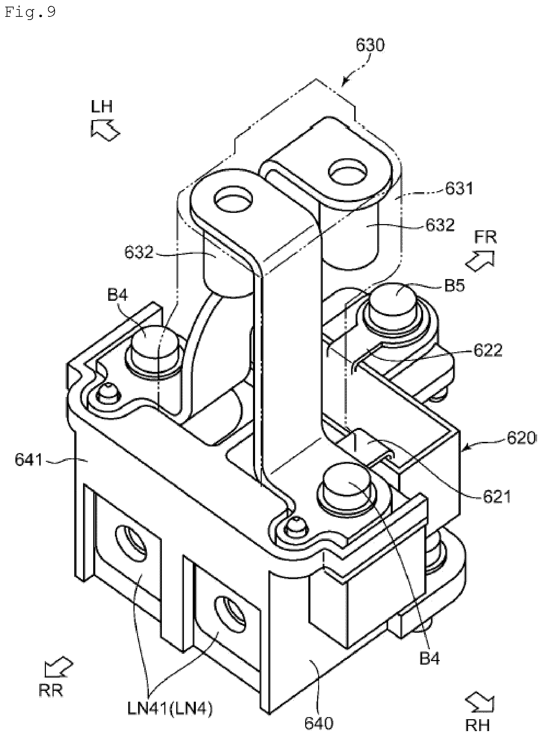

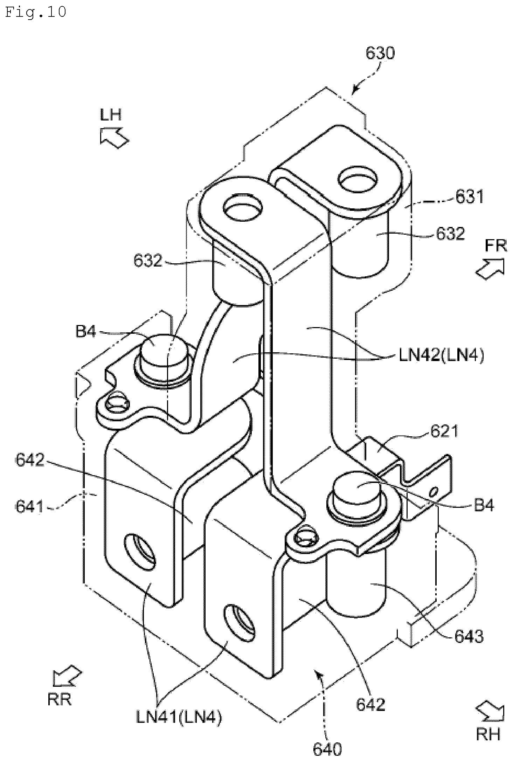

As illustrated in FIGs. 9 and 10, the lower terminal block 640 has a substantially rectangular parallelepiped block shape. The terminal block 640 includes a pair of the positive and negative lower bus bars LN41 and a pair of nut members 642, 643, and is configured that these lower bus bar LN41 and nut members 642, 643 are integrally molded (coated) by an insulation resin (resin mold 641).

Only on a rear surface and an upper surface of the lower terminal block 640, the lower bus bar LN41 is exposed to the outside from the resin mold 641. A tip portion of the DC bus bar LN2 that has entered the downward protruding portion 121 from the second motor housing 512 overlaps the lower bus bar LN41 on the rear surface of the lower terminal block 640. As illustrated in FIG. 6, the tip portion of the DC bus bar LN2 and the lower bus bar LN41 are fastened by a bolt B1 and the nut member 642, and the DC bus bar LN2 is thereby connected to the lower bus bar LN41. Such connection between the DC bus bar LN2 and the lower bus bar LN41 is made by using the tool that is inserted from the opening 122 provided in the downward protruding portion 121.

As illustrated in FIGs. 9 and 10, the upper terminal block 630 includes a pair of the positive and negative middle bus bars LN42 extending in the up-down direction and the pair of the nut members 632, and is configured that these middle bus bars LN42 and nut members 632 are integrally molded (coated) by the insulation resin (resin mold 631). As it has been described above, the upper terminal block 630 is arranged in the tube of the ferrite core 610. That is, the middle bus bar LN42 is inserted through the tube of the ferrite core 610, and thus corresponds to the "inserted portion" in the invention.

A lower end portion of the middle bus bar LN42 is bent and protrudes to the outside from the resin mold 631. The upper terminal block 630 is superimposed on an upper surface of the lower terminal block 640. On the upper surface, the lower end portion of the middle bus bar LN42 is superimposed on the lower bus bar LN41. The lower end portion of the middle bus bar LN42 and the lower bus bar LN41 are fastened by a bolt B4 and a nut member 643. As a result, the middle bus bar LN42 and the lower bus bar LN41 are connected, and the lower terminal block 640 and the upper terminal block 630 are integrally joined (coupled) to each other.

An upper surface of the upper terminal block 630 is located slightly above an upper end of the ferrite core 610. An upper end portion of the middle bus bar LN42 is bent and exposed to the outside from the resin mold 631 on the upper surface of the upper terminal block 630. As illustrated in FIGs. 6 to 8, the pair of the positive and negative upper bus bars LN43 extending forward from the smoothing unit 107 is superimposed on the upper end portion of the middle bus bar LN42, and the upper bus bar LN43 and the middle bus bar LN42 are fastened by the bolt B2 and the nut member 632. As a result, the middle bus bar LN42 and the upper bus bar LN43 are connected at a position above the ferrite core 610. That is, in the plan view, a connection portion between the middle bus bar LN42 and the upper bus bar LN43 is arranged at an overlapping position with a tubular hole of the ferrite core 610. Then, the upper bus bar LN43 extends rearward and is connected to the smoothing unit 107. Thus, the upper bus bar LN43 corresponds to the "extending portion" in the invention.

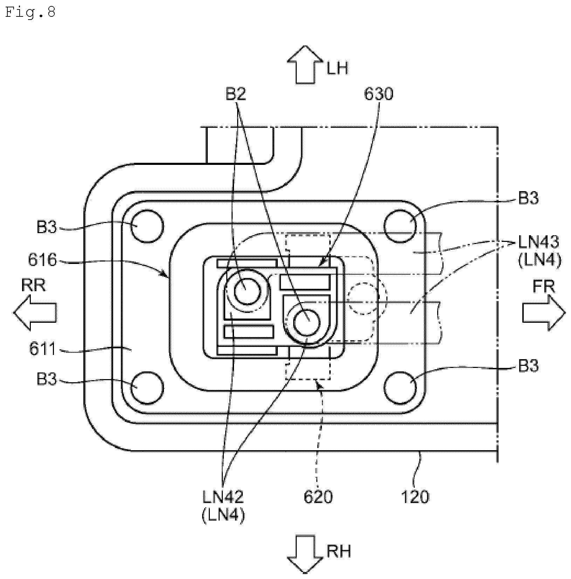

As illustrated in FIGs. 7 and 8, the Y capacitor 620 is arranged at a position below the ferrite core 610 and an overlapping position with the ferrite core 610 in the plan view. In detail, the Y capacitor 620 is arranged in a clearance between the lower terminal block 640 and a rear wall portion 121a of the downward protruding portion 121.

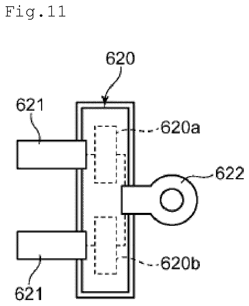

As illustrated in FIG. 11, the Y capacitor 620 includes: an element 620a that corresponds to one of a positive electrode and a negative electrode and an element 620b that corresponds to the other; a pair of line-side terminals 621 respectively connected to these elements 620a, 620b; and a ground-side terminal 622 connected across both of the elements 620a, 620b.

As shown in FIGs. 7 and 9, each of the line-side terminals 621 extends toward the lower terminal block 640, is interposed between an upper end portion of the lower bus bar LN41 and the lower end portion of the middle bus bar LN42, and is fastened to the lower terminal block 640 together with the middle bus bar LN42 by the bolt B4.

Meanwhile, the ground-side terminal 622 extends forward and is fixed to the housing body portion 120 by a bolt B5 in an upper end portion of the rear wall portion 121a. That is, the ground-side terminal 622 is grounded. As a result, at an overlapping position with the ferrite core 610 in the plan view, in a state of being connected to the DC bus bar LN4 and the inverter housing 110, the Y capacitor 620 is arranged in a clearance between the lower terminal block 640 and the rear wall portion 121a of the downward protruding portion 121.

### [Effects]

According to the structure adopted for the powertrain PT of the vehicle V according to an embodiment, it is possible to suppress the height of the inverter 100 to be low while suppressing an increase in an occupied area thereof. That is, due to provision of the recessed portion 512a, the upper contour of the second motor housing 512 in the motor housing (drive system housing) 510, in which the motor M is accommodated, generally has the arc shape or the shape similar thereto. In the powertrain PT of an embodiment, in view of such a shape of the motor housing 510, as described above, the inverter housing 110 has: the housing main portion 111 that extends in the front-rear direction; and the downward protruding portion 121 that protrudes downward from a rear end portion of the housing main portion 111. Then, the DC input/output unit 106 (secondary circuit component) is arranged in the rear end area Ar1 that overlaps the downward protruding portion 121 in the plan view of the housing main portion 111, and the DC bus bar (circuit wire) LN4 and the DC bus bar (conductive member) LN2 are connected in the downward protruding portion 121. Accordingly, the components (610 to 640) of the DC input/output unit 106 can be aligned downward (in the downward protruding portion 121) from the housing main portion 111. In this way, it is possible to suppress the height of the upper surface portion of the inverter to be low while suppressing the increase in the occupied area of the inverter 100, that is, suppressing the increase in the occupied area of the inverter 100 in the front-rear direction.

In the structure adopted for the powertrain PT of the vehicle V according to an embodiment, the DC input/output unit (secondary circuit component) 106 includes the DC bus bar (circuit wire) LN4 that extends upward from the connection portion with the DC bus bar (conductive member) LN2 through the downward protruding portion 121, and the DC input/output unit (secondary circuit component) 106 includes the ferrite core 610 that is inserted in the DC bus bar LN4. Accordingly, the noise generated in the power module unit 108 of the inverter 100, or the like is prevented from being leaked to the wire (power line harness LN1) on the DC connector CN1 side from the portion of the DC bus bar LN4 in which the ferrite core 610 is inserted and on the battery 200 side from the DC connector CN1 (an EMI measure). In addition, also in the case where the noise from another device is transmitted to the power line harness LN1, interference of the noise with driving of the inverter 100 is prevented (an EMS measure).

In the structure adopted for the powertrain PT of the vehicle V according to an embodiment, in the state where the tube axis is along the up-down direction, the ferrite core 610 is arranged in the rear end area Ar1, and the DC bus bar LN4 is inserted through the tube of the ferrite core 610. Accordingly, it is possible to suppress the portion of the inverter housing 110, in which the ferrite core 610 is accommodated (the rear end area Ar1 in the housing main portion 111), from bulging in the front-rear direction and the vehicle width direction. In this way, in the plan view of the inverter housing 110 and the motor housing 510, it is possible to prevent the inverter housing 110 from protruding from an outer shape line of the motor housing 510. Thus, also during the vehicle collision, it is possible to suppress the damage to the DC bus bar LN4 inserted through the tube of the ferrite core 610, which is advantageous to ensure the high safety.

In the structure adopted for the powertrain PT of the vehicle V according to an embodiment, the DC input/output unit 106 includes the Y capacitor 620 in addition to the ferrite core 610, and the Y capacitor 620 is disposed at the overlapping position with the ferrite core 610 in the plan view and is connected to the DC bus bar LN4 and the inverter housing 110. Accordingly, the noise generated in the power module unit 108 of the inverter 100, or the like and the noise from the outside can be bypassed to the ground. Thus, the further advanced EMS/EMI measures are established.

In the structure adopted for the powertrain PT of the vehicle V according to an embodiment, the lower terminal block 640 for connecting the DC bus bar LN4 and the DC bus bar LN2 is provided in the downward protruding portion 121, and the Y capacitor 620 is arranged between the lower terminal block 640 and the rear wall portion 121a of the downward protruding portion 121 and is connected to the DC bus bar LN4 in the downward protruding portion 121. Accordingly, it is possible to connect the Y capacitor 620 to the DC bus bar LN4 and the inverter housing 110 at a short distance. Moreover, since the Y capacitor 620 is arranged compactly in the downward protruding portion 121 together with the lower terminal block 640, it is possible to reduce the space of the rear end area Ar1 in the inverter 100, which is advantageous to suppress the increase in the occupied area of the inverter 100.

In the structure adopted for the powertrain PT of the vehicle V according to an embodiment, the DC bus bar LN4 includes: the middle bus bar (inserted portion) LN42 that is inserted through the tube of the ferrite core 610; and the upper bus bar (extending portion) LN43, the rear end portion of which is connected to the middle bus bar LN42 at the position above the ferrite core 610, and the front end portion of which is connected to the smoothing unit (main circuit section) 107. Thus, according to the structure in an embodiment, compared to a case where the connection portion between the middle bus bar LN42 and the upper bus bar LN43 in the DC bus bar LN4 is arranged at the position (outside) shifted from the position above the ferrite core 610, it is possible to suppress the enlargement of the inverter housing 110 in the front-rear direction and the vehicle width direction. Accordingly, it is possible to suppress the portion of the inverter housing 110, in which the ferrite core 610 is accommodated (the rear end area Ar1 in the housing main portion 111), from bulging in the front-rear direction and the vehicle width direction, and it is thus possible to suppress the damage to the inverter housing 110 during the vehicle collision.

In the structure adopted for the powertrain PT of the vehicle V according to an embodiment, the middle bus bar LN42 and the upper bus bar LN43 are fastened to each other and thereby connected to each other, and the pair of the positive and negative middle bus bars LN42 are coated with the resin mold 631 together with the nut member 632 for fastening the middle bus bar LN42 and the upper bus bar LN43. That is, the middle bus bar LN42 and the nut member 632 have the configuration of the single component of the upper terminal block 630. Accordingly, when the inverter 100 is assembled, the upper terminal block 630 is inserted in the tube of the ferrite core 610, that is, the middle bus bar LN42 and the nut member 632, which are molded, are integrally inserted therein, and then the middle bus bar LN42 and the upper bus bar LN43 can be fastened by using the nut member 632 at the position above the ferrite core 610. Thus, the assemblability at the time of manufacturing the inverter 100 is improved.

Moreover, according to the structure of an embodiment, since the middle bus bar LN42 is molded, it is possible to stably arrange the pair of the positive and negative middle bus bars LN42 in a state of being as close as possible, which achieves high space efficiency. This is advantageous to reduce a diameter of the ferrite core 610 and thus contributes to improvement in functionality of the ferrite core 610.

Further, in the structure adopted for the powertrain PT of the vehicle V according to an embodiment, the inverter housing 110 includes the refrigerant circulation path 124, through which the refrigerant for cooling the smoothing unit 107 and the power module unit (circuit section) 108 circulates, and the refrigerant circulation path 124 is provided in the housing main portion 111 other than the rear end area Ar1. Accordingly, it is possible to appropriately cool the power module unit 108 and the like while avoiding complication of the cooling structure. That is, in the case where the refrigerant circulation path 124 is provided in the entire inverter housing 110, it is necessary to provide the refrigerant circulation path 124 three-dimensionally in the downward protruding portion 121, which complicates the cooling structure. However, in an embodiment, the DC input/output unit (secondary circuit component) 106, which is less likely to generate heat than the power module unit (main circuit component) 108 and the like, is arranged in the rear end area Ar1, and the refrigerant circulation path 124 is provided in the inverter housing 110 other than the rear end area Ar1. Thus, it is possible to appropriately cool the heat generating components that have to be cooled, that is, the power module unit 108 and the like, while avoiding the complication of the cooling structure as described above.

In the structure adopted for the powertrain PT of the vehicle V according to an embodiment, the DC connector (electrical connection portion) CN1 is disposed in the rear wall portion (peripheral wall portion) 510b of the motor housing 510, and the DC bus bar LN2 is connected to the DC connector CN1 via the inside of the motor housing 510. Thus, according to the structure of an embodiment, the DC bus bar LN2 is protected by the motor housing 510 even during the vehicle collision. Accordingly, the damage to the DC bus bar LN2 is prevented even during the vehicle collision and the like.

### [Modified Examples]

The structure adopted for the powertrain PT of the vehicle V according to an embodiment described so far is an example of an preferred embodiment of the invention.
(1) In an embodiment, it is configured that the motor housing 510 is provided with the recessed portion 512a and the downward protruding portion 121 of the inverter housing 110 (housing body portion 120) enters the recessed portion 512a. However, when the shape of the motor housing 510 is acceptable, it may be configured that the recessed portion 512a is not provided and the downward protruding portion 121 is arranged along the peripheral wall portion of the motor housing 510.
(2) In an embodiment, the DC bus bar LN2 is adopted as the conductive member that connects the inverter 100 and the DC connector CN1. As the conductive member, for example, a coated wire can be adopted.
(3) In an embodiment, the ferrite core 610 and the Y capacitor 620 are adopted as examples of the noise filter component. However, but it is also possible to adopt the noise filter component other than the ferrite core 610. For example, a choke coil or the like can be adopted as the noise filter component.
(4) In an embodiment, the inverter 100 is applied as an example of the power converter. However, in the invention, a device other than the inverter can be applied as the power converter. For example, a DC/DC converter may be adopted as the power converter.
(5) In an embodiment, the powertrain PT includes the engine E. However, the powertrain does not always have to include the engine. That is, it is also possible to adopt the structure of the powertrain PT described above for an electric vehicle (BEV) that only includes the motor as the drive source for travel of the vehicle.

### [Reference Signs List]

100: inverter (power converter)
106: DC input/output unit (circuit section/secondary circuit component)
107: smoothing unit (circuit section/main circuit section)
108: power module unit (circuit section/main circuit component)
110: inverter housing (converter housing)
111: housing main portion
120: housing body portion
121: downward protruding portion
130: lid
140: cover
200: battery
510: motor housing (drive system housing)
610: ferrite core (noise filter component)
620: Y capacitor (noise filter component)
Ar1: rear end area
CN1: DC connector (power supply connection portion)
LN1: power line harness
LN2: DC bus bar (conductive member)
LN4: DC bus bar (circuit wire)
LN42: middle bus bar (inserted portion)
LN43: upper bus bar (extending portion)

## Claims

1. A vehicle powertrain structure comprising:
a drive system that is to be mounted on a vehicle and has a motor as a drive source for travel of the vehicle and a drive system housing (510) at least accommodating the motor;
a power converter (100) that is arranged in an upper portion of the drive system and has a circuit section for power conversion between a battery (200) and the motor and a converter housing (110) accommodating the circuit section;
a power supply connection portion (CN1) that is arranged outside the converter housing (110) and, to which a wire (LN1) extending from the battery (200) is connected; and
a conductive member (LN2) that connects the circuit section and the power supply connection portion (CN1), wherein
the converter housing (110) has: a housing main portion (111) that extends in a direction orthogonal to a rotation axis of the motor ; and a downward protruding portion (121) that protrudes downward from an end portion of the housing main portion (111),
the circuit section includes: a main circuit component that is a component having a power conversion function and is arranged in the housing main portion (111) other than an overlapping area with the downward protruding portion (121) in a plan view of the housing main portion (111); and a secondary circuit component (106) that is another component and is arranged in said overlapping area, and
the conductive member (LN2) is connected to the circuit section in the downward protruding portion (121).

2. The vehicle powertrain structure according to claim 1, wherein
the circuit section includes a circuit wire (LN4) that extends upward from a connection portion with the conductive member (LN2) and/or through an inside of the downward protruding portion (121), and
the secondary circuit component (106) includes a noise filter component in which the circuit wire (LN4) is inserted.

3. The vehicle powertrain structure according to claim 2, wherein
the noise filter component at least includes a tubular ferrite core (610),
the ferrite core (610) is arranged in said overlapping area in a state where a tube axis is along an up-down direction, and
the circuit wire (LN4) is inserted through a tubular opening of the ferrite core (610).

4. The vehicle powertrain structure according to claim 3, wherein
the noise filter component further includes a Y capacitor (620),
the Y capacitor (620) is arranged in the downward protruding portion (121), and
the Y capacitor (620) is disposed at an overlapping position with the ferrite core (610) in a plan view of the said overlapping area, and is connected to the circuit wire (LN4) and the converter housing (110).

5. The vehicle powertrain structure according to claim 4, further comprising:
a terminal block that is arranged in the downward protruding portion (121) and connects the circuit wire (LN4) and the conductive member (LN2), wherein
the Y capacitor (620) is arranged between the terminal block and a side wall portion of the downward protruding portion (121), and is connected to the circuit wire (LN4) in the terminal block.

6. The vehicle powertrain structure according to any one of claims claims 3-5, wherein
the circuit wire (LN4) includes: an inserted portion (LN42) that is inserted through the tube of the ferrite core (610); and an extending portion (LN43), one end of which is connected to the inserted portion (LN42) at a position above the ferrite core (610), and the other end of which is connected to the main circuit component.

7. The vehicle powertrain structure according to claim 6, wherein
the inserted portion (LN42) and the extending portion (LN43) are each formed of a bus bar, are fastened to each other, and are thereby connected to each other, and
the inserted portion (LN42) is molded by an insulation resin together with a fastening member for fastening the inserted portion (LN42) and the extending portion (LN43).

8. The vehicle powertrain structure according to any one of claims 1 to 7, wherein
the converter housing (110) includes a refrigerant circulation path through which a refrigerant for cooling the circuit section circulates, and
the refrigerant circulation path is provided in the housing main portion (111) other than said overlapping area.

9. The vehicle powertrain structure according to any one of claims 1 to 8, wherein
the electrical connection portion is disposed in or on a peripheral wall portion of the drive system housing (510), and
the conductive member (LN2) is connected to the electrical connection portion through the inside of the conductor housing.

10. The vehicle powertrain structure according to any one of claims 1 to 9, wherein except for the downward protruding portion (121), all other portions of the converter housing (110) are configured to have a substantially equal thickness in the up-down direction.

11. The vehicle powertrain structure according to any one of claims 1 to 10, wherein the downward protruding portion (121) is arranged at the position shifted to the inner side of the converter housing (110) when viewed in the vehicle width direction.

12. The vehicle powertrain structure according to any one of claims 1 to 11, wherein the converter housing (110) has in the plan view an area (Ar1) in a rear end portion, which is generally formed to have a narrower width in the vehicle width direction than the other portion of the converter (110), and is arranged at a position shifted to a lateral side.

13. The vehicle powertrain structure according to any one of claims 1 to 12, wherein the circuit section additionally includes an AC input/ouput unit (109), wherein the secondary unit component (106), the main circuit component and the AC input/ouput unit (109) are sequentially arranged in a longitudinal direction of the converter housing (110).

14. The vehicle powertrain structure according to any one of claims 1 to 13, wherein the converter housing (110) is configured by combining a housing body portion (120), a lid (130), and a cover (140),
wherein the lid (130) is provided with plural PCM connectors (CN3) in a manner to protrude upward,
wherein the PCM connectors (CN3) are connectors for connecting the power train control module (PCM 400) to the converter 100.

15. A vehicle comprising a vehicle power train structure as defined in any of the preceding claims.
